# EUROPEAN PATENT SPECIFICATION

(11) **EP 3 093 995 B1**
(45) Date of publication and mention of the grant of the patent: **17.06.2020**
(21) Application number: 16166123.6
(22) Date of filing: 20.04.2016
(51) Int. Cl.: H03K 19/173

(54) **INTEGRATED CIRCUIT WITH LOW POWER CONSUMPTION FOR POINT-TO-TWO-POINT SIGNAL COMMUNICATION**
INTEGRIERTE SCHALTUNG MIT NIEDRIGEM ENERGIEVERBRAUCH FÜR PUNKT-ZU-ZWEIPUNKT-SIGNALÜBERTRAGUNG
CIRCUIT INTÉGRÉ À FAIBLE CONSOMMATION D'ÉNERGIE DE COMMUNICATION DE SIGNAL POINT À DEUX POINTS

(30) Priority: 13.05.2015 EP 15167580
(43) Date of publication of application: 16.11.2016
(73) Proprietor: IMEC VZW, 3001 Leuven (BE)
(72) Inventor: Catthoor, Francky, 3001 Leuven (BE); Raghavan, Praveen, 3001 Leuven (BE)
(74) Representative: Patent Department IMEC

(56) References cited:
- US-A- 5 834 821
- US-A1- 2001 015 450
- US-A1- 2005 091 630
- US-A1- 2012 293 200

## Description

### Field

The present disclosure relates to integrated circuits, use of such circuits and methods for fabrication thereof, more in particular to integrated circuits with multiple processing units that have signal communication between them.

### State of the art

Recently in the field of integrated circuits transistors have been introduced in the back end of line, which was previously reserved for wiring purposes.

Patent application US2012/0306017 A1 discloses a Field Programmable Grid Array (FPGA) that monolithically integrates Back Gate Field Effect Transistors (BGFET) in the back end of line. The FPGA has a regular array of logic elements and discloses a crossbar switch consisting of six programmable BGFET switches that can reconfigure the connection paths between logic elements.

As some of the area of the semiconducting substrate is no longer needed for the wiring switch, the FPGA will have a smaller area: the yield is thus increased over conventional devices. Also the length of the wiring to contact the switches is reduced, thereby not only lowering the amount of parasitic resistance and capacitance, but also increasing the performance of the device. Hence US2012/0306017 A1, not only provides better performance than conventional technologies, but also does so at a lower cost.

The patent application US2012/0306017 A1 relates to a matrix structure like FPGA and alike that uses crossbar switches in a matrix structure with Manhattan or orthogonal signal routing. However, these matrix structures do not provide a minimal power consumption solution in many cases even if such programmable wiring BGFET switches are used.

US 5,834,821 A discloses a non-orthogonal three directional metal routing arrangement for minimizing wire length and intermetal capacitance in a semiconductor device. In this arrangement, electrical conductors for interconnecting terminals of microelectronic cells of an integrated circuit extend in three directions that are angularly displaced from each other by 60°.

### Summary

It is an object of the present disclosure to minimize the overall power consumption of an electrical signal in an integrated circuit, for a point-to-two-point-communication.

The above objective is accomplished by a method, a use, a device and an electronic system according to embodiments of the present disclosure.

In a first aspect the present disclosure relates to an integrated circuit, comprising at least three PU's (processing unit), each PU comprising an active-part and an interface point, and a multi-level metallization comprising: a connection-part of the PU, an interconnection connecting the three PU's at the interface points of each PU, thereby enabling point-to-two-point communication between the three PU's over the interconnection,
characterized in that, the interconnection comprises three interconnect segments and a first three-way switch embedded in the multi-level metallization, the three-way switch being connected to interface point of the three PU's through the three interconnect segments, wherein the interface points of each of the three PU's with its corresponding interconnect segment form the corners of an acute angle triangle, and wherein the first three-way switch is located in the acute angle triangle.

It is an advantage of the present disclosure that the overall power consumption is minimized for a point-to-two-point communication between three PU's.

In embodiments of the present disclosure at least one interconnect segment comprises an isolation switch embedded in the multi-level metallization.

It is an advantage of these embodiments that the isolation switch can be embedded in the multi-level metallization thereby reducing the static power consumption of the isolation cell connected to the interconnection.

It is an advantage of these embodiments that an isolation switch may be embedded in the multi-level metallization without increasing the capacitive load due to additional wiring, as would be the case for an equivalent isolation switch located in the substrate.

It is an advantage of the present disclosure that a driver circuit driving the interconnection can be reduced in size, thereby further reducing the overall power consumption of the point-to-two-point communication.

In embodiments of the present disclosure wherein at least one interconnect segment of the interconnection comprises at least one second three-way switch, embedded in the multi-level metallization, connecting the interconnect segment to a fourth interconnect segment.

It is an advantage of these embodiments that the interconnection can be part of a larger network, without affecting the power consumption of the point-to-two-point communication. The second three-way switch effectively isolates the fourth interconnect segment that may be part of the larger network, from the point-to-two-point communication. Any capacitive loading of or static power consumption connected to the fourth interconnect will not affect the power consumption of the point-to-two-point communication on the interconnection.

In embodiments of the present disclosure the integrated circuit further comprises a substrate on which the multi-level metallization is formed, and wherein the active-part of each PU, is located in the substrate, or is located in the multilevel metallization.

It is an advantage of the present disclosure that the active-part of the PU may be located in the multi-level metallization.

In embodiments of the present disclosure at least one of the PU is an input and/or output of the integrated circuit.

It is an advantage of these embodiments that the point-to-two-point communication can be with at least one input/output of the integrated circuit.

In embodiments of the present disclosure the integrated circuit comprises an interposer.

In embodiments of the present disclosure the integrated circuit is an interposer.

In embodiments of the present disclosure, the three PU are arranged in a pattern other than a matrix.

In embodiments of the present disclosure, the first three-way switch, the second three-way switch if present and the isolation switch if present comprises transistors having a leakage current density below 10e-14 Ampere per micrometre.

In embodiments of the present disclosure the first three-way switch, the second three-way switch if present and the isolation switch if present are controlled by a controller.

In a second aspect the present disclosure relates to an electronic system, comprising an integrated circuit according to embodiments of the first aspect.

In a third aspect the present disclosure relates to the use of an integrated circuit according to first aspect for a low power consumption point-to-two-point signal communication between the three PU.

In a fourth aspect the present disclosure relates to a method for fabricating an integrated circuit according to the first aspect, the method comprising, forming a multi-level metallization on top of a substrate, forming at least three PU's (processing unit), each PU comprising an active-part in the substrate or in the multilevel metallization, each PU further comprising a connection-part and an interface point in the multi-level metallization. Wherein forming the multi-level metallization comprises forming an interconnection connecting the three PU's at the interface points of each PU, thereby enabling point-to-two-point communication between the three PU's over the interconnection. Wherein, forming the interconnection comprises forming a first three-way switch embedded in the multi-level metallization connected to the three PU's through three interconnect segments, wherein the three PU's are formed such that the interface point of each of the three PU's, connected with its corresponding interconnect segment of the interconnection, form the corners of an acute angle triangle whereby the first three-way switch is located in the acute angle triangle.

In embodiments, the method wherein at least one interconnect segment comprises an isolation switch, embedded in the multi-level metallization.

In embodiments, the method further comprises providing a second three-way switch, embedded in the multi-level metallization, connected to a fourth interconnect segment, wherein at least one interconnect segment of the interconnection comprises the second three-way switch thereby connecting the interconnect segment to the fourth interconnect segment.

### Brief description of the figures

FIG 1a illustrates a cross sectional view of an integrated circuit according to an exemplary embodiment of the present disclosure.
FIG 1b illustrates a cross sectional view of an integrated circuit according to an exemplary embodiment of the present disclosure
FIG 2 illustrates a plan view of an integrated circuit according to an exemplary embodiment of the present disclosure.
FIG 3 illustrates a plan view of an integrated circuit according to an exemplary embodiments of the present disclosure comprising isolation switches.
FIG 4 illustrates a plan view of an integrated circuit according to an exemplary embodiments of the present disclosure comprising a second three-way switch.

### Detailed description

The present disclosure is described with respect to particular embodiments and with reference to certain drawings but the disclosure is not limited thereto but only by the claims. The drawings described are only schematic and are nonlimiting. In the drawings, the size of some of the elements may be exaggerated and not drawn on scale for illustrative purposes. The dimensions and the relative dimensions do not correspond to actual reductions to practice of the disclosure.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the disclosure described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present disclosure, the only relevant components of the device are A and B.

Reference throughout this specification to "one embodiment" or "an embodiment" means that a particular feature, structure or characteristic described in connection with the embodiment is included in at least one embodiment of the present disclosure. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the disclosure, various features of the disclosure are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed disclosure requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this disclosure.

Furthermore, while some embodiments described herein include some but not other features included in other embodiments, combinations of features of different embodiments are meant to be within the scope of the disclosure, and form different embodiments, as would be understood by those in the art. For example, in the following claims, any of the claimed embodiments can be used in any combination.

In the description provided herein, specific details are set forth. However, it is understood that embodiments of the disclosure may be practiced without these specific details. In other instances, well-known methods, structures and techniques have not been shown in detail in order not to obscure an understanding of this description.

The Integrated circuits according to embodiments of the present disclosure are generally fabricated by a planar technology. They comprise a substrate **101** and a multi-level metallization **150.** The substrate **101** typically may be a semiconductor wafer, and may comprise active devices for example transistors, diodes, etc. and/or passive devices for example resistors, capacitors, inductors, etc. The multi-level metallization **150** comprises a multitude of layers on a main surface of the substrate **101** and may comprise connections, also known as wirings and/or contacts to for example the devices in the substrate, and/or connections or wiring to and between the different devices and parts of the integrated circuit **100.** Typically the multi-level metallization **150** has as least two levels, each level may be for example a Cu damascene layer, more particular: a single damascene or a double damascene layer as known in the art. The substrate **101** comprising the active devices is also known in the art as the Front-End-Of-Line or FEOL **140.** The multi-level metallization is also known in the art as Back-End-Of-Line or BEOL.

The substrate **101** may comprise an active-part of a processing unit (PU) **110,** the active-part performs for example a logic or computational function of the PU. The PU **110** may have a wide range of complexity, for example but not limited to: an N-bit ALU with N being an integer number larger than 1, a micro core, a memory or even a full processor core or storage node. For a given technology node the more complex the PU **110** the larger its size. At least one PU **110** may have its active-part embedded in the multi-level metallization **150,** the active-part of that PU comprising transistors having a leakage current density below 10e-10, or below 10e-12, or below 10e-14 or even below 10e-16 Ampere per micrometre. For example Thin Film Technology (TFT) transistors embedded in the multi-level metallization.

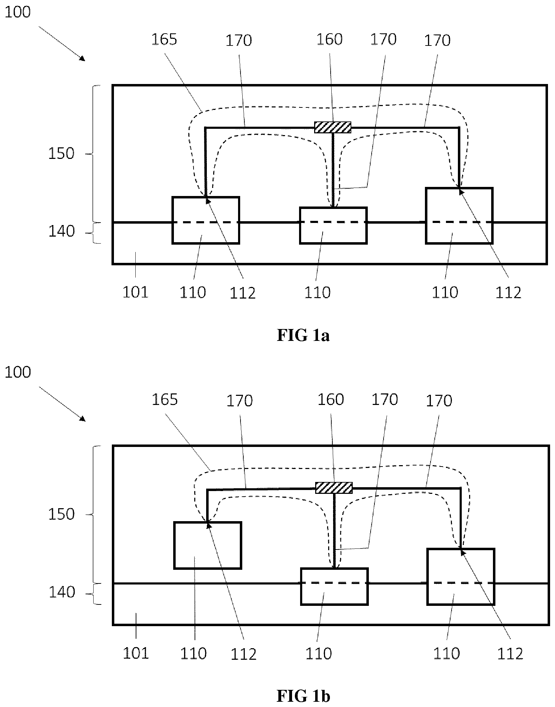

The connection-part of the PU **110** comprising the connections, wiring or routing inside a given PU **110** may be formed in the multi-level metallization **150,** and may be restricted to a limited number of levels of the multi-level metallization **150.** It is clear to the skilled person that the connection-part of the PU **110** when restricted to a number of levels is typically restricted to a limited number of metallization levels of the multi-level metallization **150,** closest to the active-part of the PU **110.** As illustrated by the different heights of the PU **110** and interface points **112** in FIG 1a, a first PU **110** may have wirings inside the first PU limited to a first limited number of levels of the multi-level metallization, a second PU may have wirings inside the second PU limited to a second limited number of levels of the multi-level metallization and a third PU may have wirings inside the third PU limited to a third limited number of levels of the multi-level metallization.

The PU **110** may have its computational or active-part in the substrate 101 or in the multi-level metallization **150,** the PU further has its connection-part in the multi-level metallization **150.** The connection-part of the PU **110** comprises the connections, for example the physical routing in the metallization levels, of that PU **110** needed to contact the computational part of the PU **110,** such that the PU **110** can perform the logic function that it is designed for.

The active-part and the connection-part of the PU **110** are generally of the same size, i.e. have the same footprint when looked at in a plan view, whereby both parts coincide. It is clear that the active-part and connection-part may have different sizes, i.e. footprint, but are generally overlapping. It will be clear that when both the active-part and the connection-part of the PU are comprised in the multi-level metallization that they preferably form a single physical entity, with a limited number of levels of the multi-level metallization that preferably does not contain the level closest to the substrate **101.**

FIG 1a shows a cross-section of an integrated circuit **100** according to an examplary embodiment of the present disclosure. The integrated circuit **100** comprises at least three PU's (processing unit) **110.** The integrated circuit **100** comprises a FEOL **140** formed in a substrate **101** and a multi-level metallization **150** formed on the substrate **101.** The multi-level metallization **150** comprises the connections that are part of the PU **110** (not shown) and an interconnection **165** connecting the three PU's **110.** The interconnection **165** is formed in the multilevel metallization whereby the interconnection **165** comprises at least two metallization level. The substrate **101** comprises the active-part of the PU **110,** as illustrated by the dotted line in FIG 1a representing the boundary between the substrate containing this active-part and the multi-level metallization within a PU **110.** A first three-way switch **160** embedded in the multi-level metallization **150** is connected to each of the three PU's **110** through three interconnect segments **170,** one interconnect segment **170** for each PU **110.** Each interconnect segment **170** and the first three-way switch are part of the interconnection **165,** interconnecting the three PU's **110.** A first PU is connected to the first three-way switch **160** through a first interconnect segment, the second PU is connected to the first three-way switch **160** through a second interconnect segment and the third PU is connected to the first three-way switch **160** through a third interconnect segment. Each of the three interconnect segments is connected to one of the three main switching points of the first three-way switch **160.**

The interconnection **165** in the multi-level metallization **150** electrically connects for example an input or output of a PU **110** to a corresponding output or input of the other PU's **110** connected to the interconnection **165.** The interconnection **165** may propagate an electrical signal from a first PU to a second and/or third PU. The electrical signal may be a representation of a logic signal. PU's may thus communicate through the propagation of an electrical signal over the interconnection **165,** through the interconnect segments **170.**

There may be multiple interconnections **165** between the three PU **110,** for instance to carry an N-bit signal, with N being and integer number larger than one. In this case the communication is based on N separate interconnections **165** also called an N-bit signal bus.

The interconnection **165** in the integrated circuit **100** has a given capacitive loading or capacitive load depending on its physical implementation within the multi-level metallization **150.** The multi-level metallization **150** comprises a plurality of physical connections, also known as: wiring or routing, embedded in a dielectric material. The multi-level metallization **150** may be for example a multi-level double damascene Cu metallization. The interconnection **165** may be formed in a plurality of metallization levels, each metallization level may comprise a METAL, a VIA or both as known in the art. The multi-level metallization comprises at least two metallization levels, but typically has more levels, for example 4, 6, 8 or more.

The interconnection **165** will propagate the logic signal from one PU to at least one other PU during signal communication. During signal communication the logic signal may change state, the corresponding electrical signal on the interconnection **165** will then also change. Each change in the electrical signal will charge or discharge the capacitive load of the interconnection **165** to propagate the changing electrical signal thereby giving rise to a corresponding dynamic power consumption. The dynamic power consumption is proportional to the capacitive loading of the interconnection **165** and the activity of changes in the electrical signal within a given time period. It is clear that the dynamic power consumption is also depending on the voltage excursion of the electrical signal. It is assumed in the present disclosure that this voltage excursion is the same or substantially similar over all the segments during a point-to-point or point-to-two-point communication, this assumption is should be respected when comparing power consumption between: the minimum capacitive loading interconnect segments 180 and the interconnect segments **170** part of the interconnection **165.**

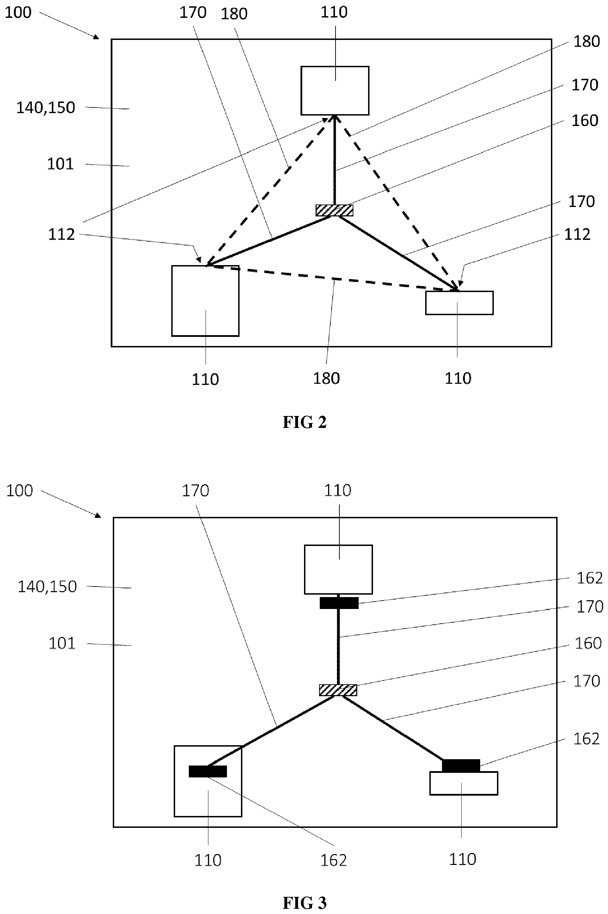

FIG 2 illustrates a plan view of an examplary embodiment of an integrated circuit **100,** comprising at least three PU's (processing unit) **110,** each PU **110** comprising an active-part and an interface point **112.** The integrated circuit further comprising a multi-level metallization **150** comprising: a connection-part of the PU **110,** and an interconnection **165** connecting the three PU's **110** at the interface points **112** of each PU **110,** the interconnection (165) comprises three interconnect segments (170) and a first three-way switch (160) embedded in the multi-level metallization (150), the three-way switch (160) being connected to interface point (112) of the three PU's (110) through the three interconnect segments (170), wherein the capacitive loading of the three interconnect segments (170) is less than when compared to the capacitive loading provided when the three PU (110) are connected using any selected set of two point-to-point minimum capacitive loading interconnect segments (180) connecting the three PU's (110).

As the first three-way switch **160** is comprised within the multi-level metallization **150** it is clear that the first three-way switch **160** is embedded in the multi-level metallization **150.**

Connecting the three PU's **110** together through the interconnection **165** enables point-to-two-point communication between the three PU's **110** over that interconnection **165.** The three PU's **110** are contacted through the interface points **112** to the interconnection **165.** The capacitive loading of the interconnection **165,** having three interconnect segments **170,** is less than the sum of the capacitive loading of any selected set of two minimum capacitive loading interconnect segments **180.** This results in a dynamic power consumption for a point-to-two-point communication over the interconnection **165** and between the three PU's **110** that is lower than the dynamic power consumption obtained by a combination of two minimum capacitive loading interconnect segments **180** connecting the same three PU's for the same communication.

The minimum capacitive loading interconnect segments **180** are represented by the dotted lines in FIG 2. Any point-to-point communication, between a set of two selected PU's, through the minimum capacitive loading interconnect segment **180** having a minimum capacitive load, yields the lowest dynamic power for that point-to-point communication between the two selected PU's. Note that point-to-point communication is actually communication between two PU's. Point-to-two-point communication is communication from one PU to two other PU's or communication between the three PU's.

For a point-to-two point communication, without interconnection **165** and without a three-way switch **160** as in the present disclosure, a combination of two point-to-point interconnect segments is needed for point-to-two-point communication. The lowest dynamical power will be obtained if the two point-to-point interconnect segments are the minimum capacitive loading interconnect segments **180.** From the three point-to-point interconnect segments that may be available, the two interconnect segments that have the lowest dynamical power consumption must be selected.

Embedding the first three-way switch **160** in the multi-level metallization **150** further reduces the capacitive load, as no connections are needed to the FEOL **140** that would make the interconnection **165** longer and increase the capacitive loading of the interconnection **165.**

Embedding the first three-way switch **160** in the multi-level metallization **150** reduces the static power consumption compared to a first three-way switch **160** made in the FEOL **140,** when the leakage of the multi-level metallization switch is lower than the FEOL version of that switch.

According to an embodiment of the present disclosure the first three-way switch **160** may consist of transistors having a leakage current density below 10e-10, or below 10e-12, or below 10e-14 or even below 10e-16 Ampere per micrometre. This may be achieved by using for example a thin film technology (TFT) embedded in a metallization level of the multi-level metallization. Such TFT devices for example IGZO devices known in the art and will not be described here in detail. A typical FEOL switch may have a typical leakage current density of 10e-7 Ampere per micrometre.

The overall power consumption is the sum of the static and dynamic power consumption. The overall power consumption of the point-to-two-point communication through the interconnection **165** and the first three-way switch according to the present disclosure is lower than compared to a combination of two point-to-point minimum capacitive loading interconnect segment **180** communication.

The interface points **112** of the PU **110,** as illustrated in FIG 2, are the points where the interconnect segments **170** are physically connected to the PU **110.** The interface point **112** may be connected to an input, an output or to a bidirectional function within the PU **110.** The interface point may be a metal connection, also called pin of the PU **110,** of a metallization level in the multi-level metallization **150** at the boundary of the PU **110.** The interface point **112** of a PU **110** may then be part of the limited number of levels of the multilevel metallization of that PU as previously defined. It is clear to the skilled person that three PU's **110** may have an interface point **112** on the same metallization level or at different metallization levels, as illustrated in FIG 1a by the different heights of each PU in the multi-level metallization **150.**

The first three-way switch **160** may be located in a metallization level in between, the limited number of levels of the multi-level metallization level of a PU **110** forming the connection-part of that PU and the maximum or highest metallization level which is located furthest away from the FEOL **140.** In this case the first three-way switch **160** may be located above that PU **110.** This may further reduce the capacitive loading of the interconnection **165.**

According to an embodiment of the present disclosure and illustrated in FIG 3, the integrated circuit wherein at least one interconnect segment **170** comprises an isolation switch **162** embedded in the multi-level metallization **150.** So that at least one of the PU's **110** may be connected to the first three-way switch **160** through its corresponding interconnect segment **170** which has an isolation switch **162** that is embedded in the multi-level metallization **150.** The capacitive loading of the isolation switch **162** may be taking into account when calculating the capacitive loading of the interconnect segment **170.** The overall power consumption of a PU **110** may be optimized by disconnecting at least part of the connected interconnect segment **170** from that PU **110** by opening the isolation switch **162** embedded in the multi-level metallization **150.** This reduces the capacitive load seen by the PU **110.** It will be clear that the isolation switch is closed when the point-to-two-point communication is ongoing. When there is no point-to-two-point communication the isolation switch can be opened. The isolation switch **162** advantageously has transistors with a leakage current density below 10e-10, or below 10e-12, or below 10e-14 or even below 10e-16 Ampere per micrometre. The isolation switch **162** may advantageously be located as close as possible to the interface point **112** of the PU **110** to maximize the part of the interconnect segment being disconnected or isolated from that PU **110,** the interconnect segment **170** then comprises the isolation switch **162.** In case the limited number of levels of the multi-level metallization of a PU **110** includes the level where the isolation switch **162** may be embedded in the multi-level metallization, it is possible to locate the isolation switch **162** next to the PU **110.** The low leakage of the isolation switch **162** lowers the static power consumption on the interconnection **165** compared to an equivalent FEOL implementation. This is advantageous as any driver or buffer that drives the interconnection **165** may be reduced in size which lowers the overall power consumption for a point-to-two-point communication. These drivers or buffers may be formed in the FEOL **140** and may be part of the PU **110** driving the electrical signal through the interface point **112** on the interconnection **165.** Alternatively these drivers may be formed with low leakage transistors embedded in the multi-level metallization **150** and used for example as buffer or repeater to drive the capacitive loading of the interconnection **165.**

Advantageously all three PU's **110** may be connected to an isolation switch **162.** Advantageously the isolation switch **162** and the first three-way switch **160** are embedded in the same metallization level of the multi-level metallization **150.**

Fig 3 illustrates three examplary embodiments for the isolation switch **162** location with respect to the PU **110** it is connected with. In a first examplary embodiment the isolation switch **162** is located at a distance from the PU **110.** In a second examplary embodiment the isolation switch **162** is located next to the PU **110.** In the third examplary embodiment the isolation switch is located above the PU **110.**

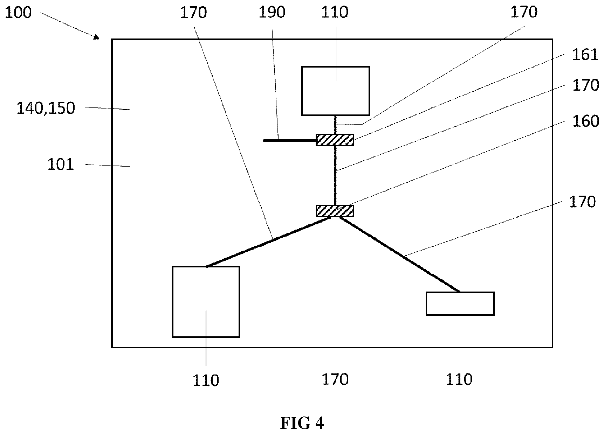

The integrated circuit **100** according to embodiments of the current disclosure and as illustrated in FIG 4, comprises an interconnection **165,** the interconnection **165** comprising three interconnect segments **170.** At least one interconnect segment **170** of the interconnection **165** may comprises at least one second three-way switch **161,** preferably embedded in the multi-level metallization **150,** connecting the interconnect segment **170** to a fourth interconnect segment **190** not part of the interconnection **165.** The fourth interconnect segment **190** may be connected to: a primary input or output, a fourth PU, another three-way or isolation switch. The capacitive loading of the second three-way switch **161** may be taking into account when calculating the capacitive loading of the interconnect segment **170.** The fourth interconnect segment **190** is not part of the interconnection and must not be taken into account for the capacitive loading of that interconnection. The second three-way switch **161** should be looked upon as closed, during point-to-two-point communication, and as such interconnecting the two parts of the interconnect segment **170** connected to the second three-way switch **161** that are part of the interconnection **165.** The fourth interconnect segment **190** may not be involved in the point-to-two-point communication between the three PU **110.** The second three-way switch **161** is preferably also embedded in the multi-level metallization and preferably in the same metallization level as the first three-way switch **160** and isolation switch **162** if present. To further optimize the static power consumption and overall power consumption the second three-way switch **161** may consist of transistors having a leakage current density below 10e-10, or below 10e-12, or below 10e-14 or even below 10e-16 Ampere per micrometre. This may be achieved by using for example a thin film technology (TFT) embedded in a metallization level of the multi-level metallization. The second three-way switch **161** may be controlled by a controller. The controller may advantageously be part of the integrated circuit **100.** The controller may open or close a selected set of switches from the second three-way switch **161** in accordance to the communication being required or not required on any of the relevant segments.

According to embodiments of the present disclosure, the integrated circuit may further comprising a substrate **101** on which the multi-level metallization **150** is formed, and wherein the active-part of each PU **110** is located in the substrate **101,** or is located in the multilevel metallization **150.** Fig 1b illustrates both the embodiment where the active-part of a PU **110** is located in the multi-level metallization **150** and in the substrate **101.**

According to embodiments this substrate can be an interposer.

According to embodiments of the present disclosure at least one of the PU's **110** may be an input and or output of the integrated circuit **100.** The PU may be a primary input, a primary output or a primary bidirectional port, for example a pad cell for external access or a trough substrate via (TSV) to connect the integrated circuit **100** to a next level of an electronic device comprising the integrated circuit **100.**

According to embodiments of the present disclosure the integrated circuit can be an interposer of which at least one PU is a primary input, a primary output or a primary bidirectional port. The interposer may be an active or passive interposer.

According to an embodiment of the present disclosure the interface point **112** of each of the three PU's **110,** involved in the point-to-two-point communication, which are connected to the first three-way switch **160** through the three interconnect segments **170** of the interconnection **165** are the vertices or corners of an acute angle triangle and as such the three interconnect segments **170** for an acute angle triangle,. Each interface point **112** is a corner or vertex of that acute angle triangle. In the acute angle triangle each angle of the triangle is an acute angle. This acute angle triangle, as seen from the plan view of the integrated circuit **100** on the main planar surface of the substrate **101,** is defined by the physical location between the three interface points **112** of the three PU's **110.** The acute angle triangle is illustrated in FIG 2 by the three dotted lines, each dotted line represent the minimum capacitive loading interconnect segments **180** for a given point-to-point communication between two PU's at the endpoints of that dotted line.

According to an embodiment of the present disclosure the first three-way switch **160** may be located within the acute angle triangle. Physically locating the first three-way switch **160** within the acute angle triangle may reduce the capacitive loading of the interconnection **165.** It is clear to the skilled person that the interface points **112** of the three PU **110** and the first three-way switch **160** may be each on a different metallization level. Both the acute angle triangle and the first three-way switch **160** location are as seen in a plan view of the integrated circuit **100** of the main planar surface of the substrate **101.**

According to an embodiment of the present disclosure the three way switch **160** may be located on a centroid of the acute angle triangle, this may correspond to a minimum capacitive loading of the interconnection **165,** provided the three interconnect segments **170** can be physically minimized to achieve minimum capacitive loading from the respective PU to the first three-way switch **160.**

For an integrated circuit **100** according to embodiments of the present disclosure, the interface point **112** of each of the three PU **110** with its corresponding interconnect segment **170** is the corner or vertex of an equilateral triangle.

It is clear to the skilled person that in practical realizations at least one of the interconnect segments **170** connecting the three PU's **110** may be physically blocked by an obstruction, for example a large macro block or a keep out zone above an RF-coil where no signal metallization may be allowed during integration or physical implementation. This obstructions impacts or increases the minimum capacitive load that can practically or physically be achieved. It is clear to skilled person that in practical realizations at least one of the minimum capacitive loading interconnect segments **180** may be physically blocked by an obstruction, for example a large macro block or a keep out zone above an RF-coil where no signal metallization may be allowed during integration or physical implementation, impacting or increasing the minimum capacitive load that can practically of physically be achieved. It is also clear that present physical implementations or routing of the interconnection **165,** interconnect segment or any other connection between the PU, is generally done in a Manhattan style with a preferred direction for each metallization level, preventing straight single metallization level interconnects between for example the PU **110** and the first three-way switch **160,** and also between two PU's for having minimum capacitive loading interconnect segments **180.** For distances larger than for example 10x, 20x, 50x, 100x or more times the minimum metal pitch of the metallization level in the multi-level metallization **150** the interconnect segments **170** represented by a single straight line may be approximated by a Manhattan style routing. In any case the capacitive loading of the routing may be minimized taking routing blockages and other physical constraints of any metallization level into account. In the present disclosure the minimum capacitive loading interconnect segment **180** may be seen as the minimum capacitive loading possible in practical or physical implementations of the interconnect segment, taking: physical blockages, eventual Manhattan style routing and eventual multilevel routing in to account. In the present disclosure the capacitive loading of the three interconnect segments **170** may be seen as the capacitive loading in practical or physical implementations of the interconnect segment **170,** taking physical blockages, eventual Manhattan style routing and eventual multilevel routing into account.

In an examplary integrated circuit **100** according to the present disclosure the three segments **170** may be formed in a single layer or in a set of layers of the multilayer multi-level metallization that are closest to the embedded switches.

According to embodiments of the present disclosure the three PU's **110** are arranged in a pattern other than a two dimensional matrix. The pattern must be looked at in a plan view of the integrated circuit **100** of the main planar surface of the substrate **101.** In FPGA, programmable logic device (PLD) and the likes a plurality of PU's are located in a regular 2-D matrix structure having a given first and second pitch in the plan view of the main surface of the substrate. A matrix structure may be an array type arrangement of a multitude of PU's located and arranged in a row and column structure in the plan view of the main surface of the substrate. In the current disclosure the location or placement of the three PU's **110** in the integrated circuit **100** may not be organized in a matrix structure as seen in the plan view of the main surface of the substrate. The three PU's **110** may be different in size and aspect ratio. The location of the interface points **112** may not be the same for any of the three PU's the metallization level of interface points **112** may be different between different PU **110.** The interconnection **165** according to the present disclosure may be part of a plurality of wirings in the multi-level metallization. The integrated circuit **100** may be: a system on chip (SOC), an application specific integrated circuit (ASIC), a memory organisation with several partitions, a neuromorphic platform with synapse clusters, a full custom digital or mixed mode integrated circuit, or an interposer on a substrate preferably a semiconductor substrate. The integrated circuit **100** is not an FPGA, PLD, PLA, or the likes, with a matrix structured location or organization of the PU's and a routing that may be reprogrammed.

According to embodiments of the present disclosure the first three-way switch (160), the second three-way switch (161) if present and the isolation switch (162) if present comprises transistors having a leakage current density below 10e-10, or below 10e-12, or below 10e-14 or even below 10e-16 Ampere per micrometre.

The first and second three-way switch **160, 161** may comprise at least three switches in star or triangle configuration. Each switch having two switching points, the switch is open or closed with respect to those switching points: when a switch is closed the switching points are electrically connected and when the switch is open the switching points are electrically isolated or disconnected. The main switching points of a three-way switch are the switching points that may be connected to the interconnect segments **170.** Each switch may be at least 1 transistor, for example an NMOS in for example a TFT implementation. The three-way switch **160** when implemented in a star configuration, has a star-point that is part of the interconnection **165.** The star-point is not a main switching point for the first three-way switch **160,** as it is not connected to the interconnect segment **170.** The three-way switch **160** when implemented in a triangle configuration, may have three switches that each connect to a main switching point.

According to embodiments of the present disclosure the first three-way switch **160,** the second three-way switch **161** if present and the isolation switch **162** if present are controlled by a controller. The controller may advantageously be part of the integrated circuit **100.** The controller may open or close the isolation switch **162** and each of the switches of the first or second three-way switch **160,161** in accordance to the communication required on any of the segments **170.** If no communication is required on a segment **170,** that segment may be fully isolated on one or both ends by a switch. The controller may control the switches through control lines from the controller to the switches.

The present disclosure also relates to an electronic system, comprising an integrated circuit according to the foregoing embodiments of the present disclosure.

The present disclosure also relates to the use of an integrated circuit according to the foregoing embodiments for a low power consumption point-to-two-point signal communication between the three PU's.

The present disclosure also relates to a method for fabricating an integrated circuit according to the foregoing embodiments of the disclosure, the method comprises forming a multi-level metallization **150** on top of a substrate **101,** forming at least three PU's (processing unit), each PU **110** comprising an active-part in the substrate **101** or in the multilevel metallization **150.** The active-part of the PU when present in the substrate, is formed during the Front End Of Line (FEOL) processing. The active-part of the PU present in the multi-level metallization is formed during the Back End Of Line (BEOL) processing. Each PU **110** further comprising a connection-part and an interface point **112** in the multi-level metallization **150,** wherein forming the multi-level metallization **150** comprises forming an interconnection **165** connecting the three PU's **110** at the interface points **112** of each PU **110.** Forming the interconnection **165** comprises forming a first three-way switch **160** embedded in the multi-level metallization **150** connected to the three PU's **110** through three interconnect segments **170,** whereby the capacitive loading of the three interconnect segments **170** is less than when compared to the capacitive loading provided when the three PU's **110** are connected using any selected set of two point-to-point minimum capacitive loading interconnect segments **180** connecting the three PU's **110.** Physically locating the three PU's **110** and the first three-way switch **160** such that when connecting the first three-way switch **160** to the three PU **110** through three interconnect segments **170,** the capacitive loading of the three interconnect segments **170** is less than the capacitive loading provided by any selected set of two minimum capacitive loading interconnect segments **180** connecting the three PU's **110.** The physical location of the three PU's **110** and the first three-way switch **160** may be seen as their location or placement in a plan view of the main surface of the substrate.

The location of the three PU **110,** in a plan view of the integrated circuit, may be such that when forming the three PU **110** the interface point **112** of each of the three PU's **110,** connected to its corresponding interconnect segment **170** of the interconnection **165,** form the corners of an acute angle triangle whereby the first three-way switch **160** is located in the acute angle triangle. The interface point **112** of each of the three PU's **110** are the corner point or vertex that form an acute angle triangle when connected by a straight line. The first three-way switch **160** may be located within the acute angle triangle.

The method further comprises providing an isolation switch **162,** embedded in the multi-level metallization **150,** in the interconnect segment **170** of at least one of the PU 's**110**. So that at least one interconnect segment **170** comprises an isolation switch **162,** embedded in the multi-level metallization **150.**

The method may further comprise providing a second three-way switch **161** embedded in the multi-level metallization **150,** whereby at least one interconnect segment **170** of the interconnection **165** comprises the second three-way switch **161,** connecting the interconnect segment **170** to a fourth interconnect segment **190** not part of the interconnection **165.**

## Claims

1. An integrated circuit (100), comprising:
- at least three processing units, PU's (110), each PU (110) comprising an active-part and an interface point (112), and;
- a multi-level metallization (150) comprising: a connection-part of the PU (110), an interconnection (165) connecting the three PU's (110) at the interface points (112) of each PU (110), thereby enabling point-to-two-point communication between the three PU's (110) over the interconnection (165);
**characterized in that**,
the interconnection (165) comprises three interconnect segments (170) and a first three-way switch (160) embedded in the multi-level metallization (150), the three-way switch (160) being connected to interface point (112) of the three PU's (110) through the three interconnect segments (170), wherein the interface points (112), of each of the three PU's (110) with its corresponding interconnect segment (170) form the corners of an acute angle triangle, and wherein the first three-way switch (160) is located in the acute angle triangle.

2. The integrated circuit according to claim 1, wherein at least one interconnect segment (170) comprises an isolation switch (162) embedded in the multi-level metallization (150).

3. The integrated circuit according to any of the preceding claims, wherein at least one interconnect segment (170) of the interconnection (165) comprises at least one second three-way switch (161), embedded in the multi-level metallization (150), connecting the interconnect segment (170) to a fourth interconnect segment (190).

4. The integrated circuit according to any of the preceding claims, further comprising a substrate (101) on which the multi-level metallization (150) is formed, and wherein the active-part of each PU (110) is located in the substrate (101), or is located in the multilevel metallization (150).

5. The integrated circuit according to any of the preceding claims, wherein at least one of the PU's (110) is an input and/or output of the integrated circuit (100).

6. The integrated circuit according to any of the preceding claims, wherein the integrated circuit is an interposer.

7. The integrated circuit according to any of the preceding claims, wherein the three PU's (110) are arranged in a pattern other than a matrix.

8. The integrated circuit according to any of the preceding claims, wherein the first three-way switch (160), the second three-way switch (161) if present and the isolation switch (162) if present comprises transistors having a leakage current density below 10e-14 Ampere per micrometre.

9. The integrated circuit according to any of the preceding claims, wherein the first three-way switch (160), the second three-way switch (161) if present and the isolation switch (162) if present are controlled by a controller.

10. An electronic system, comprising an integrated circuit according to any of the preceding claims.

11. The use of an integrated circuit (100) according to claims 1 to 9, for a low power consumption point-to-two-point signal communication between the three PU's (110).

12. A method for fabricating an integrated circuit (100) according to any of the claims 1 to 9, the method comprising:
- forming a multi-level metallization (150) on top of a substrate (101),;
- forming at least three PU's (processing unit, 110), each PU (110) comprising an active-part in the substrate (101) or in the multilevel metallization (150), each PU (110) further comprising a connection-part and an interface point (112) in the multi-level metallization (150);
- wherein forming the multi-level metallization (150) comprises forming an interconnection (165) connecting the three PU's (110) at the interface points (112) of each PU (110) thereby enabling point-to-two-point communication between the three PU's (110) over the interconnection (165);
wherein:
forming the interconnection (165) comprises forming a first three-way switch (160) embedded in the multi-level metallization (150) connected to the three PU's (110) through three interconnect segments (170), wherein the three PU's (110) are formed such that the interface point (112) of each of the three PU's (110), connected with its corresponding interconnect segment (170) of the interconnection (165), form the corners of an acute angle triangle whereby the first three-way switch (160) is located in the acute angle triangle.

13. The method for fabricating an integrated circuit according to claim 12, wherein at least one interconnect segment (170) comprises an isolation switch (162), embedded in the multi-level metallization (150).

## Patentansprüche

1. Integrierte Schaltung (100), umfassend:
- mindestens drei Verarbeitungseinheiten, PUs (110), wobei jede PU (110) einen aktiven Teil und einen Schnittstellenpunkt (112) umfasst und;
- eine mehrschichtige Metallisierung (150), umfassend: einen Verbindungsteil der PU (110), eine Vernetzung (165), die die drei PUs (110) bei den Schnittstellenpunkten (112) jeder PU (110) verbindet, wodurch Punkt-zu-Zweipunkt-Kommunikation zwischen den drei PUs (110) über die Vernetzung (165) ermöglicht wird;
**dadurch gekennzeichnet, dass**
die Vernetzung (165) drei Vernetzungssegmente (170) und einen ersten Dreiwegeschalter (160), der in der mehrschichtigen Metallisierung (150) eingebettet ist, umfasst, wobei der Dreiwegeschalter (160) mit Schnittstellenpunkt (112) der drei PUs (110) durch die drei Vernetzungssegmente (170) verbunden ist, wobei die Schnittstellenpunkte (112) jeder der drei PUs (110) mit ihrem entsprechenden Vernetzungssegment (170) die Ecken eines spitzwinkligen Dreiecks bilden und wobei der erste Dreiwegeschalter (160) im spitzwinkligen Dreieck liegt.

2. Integrierte Schaltung nach Anspruch 1, wobei mindestens ein Vernetzungssegment (170) einen Isolierungsschalter (162) umfasst, der in der mehrschichtigen Metallisierung (150) eingebettet ist.

3. Integrierte Schaltung nach einem der vorstehenden Ansprüche, wobei mindestens ein Vernetzungssegment (170) der Vernetzung (165) mindestens einen zweiten Dreiwegeschalter (161) umfasst, der in der mehrschichtigen Metallisierung (150) eingebettet ist, die das Vernetzungssegment (170) mit einem vierten Vernetzungssegment (190) verbindet.

4. Integrierte Schaltung nach einem der vorstehenden Ansprüche, weiter umfassend ein Substrat (101), auf dem die mehrschichtige Metallisierung (150) gebildet ist, und wobei der aktive Teil jeder PU (110) im Substrat (101) liegt oder in der mehrschichtigen Metallisierung (150) liegt.

5. Integrierte Schaltung nach einem der vorstehenden Ansprüche, wobei mindestens eine der PUs (110) ein Eingang und/oder Ausgang der integrierten Schaltung (100) ist.

6. Integrierte Schaltung nach einem der vorstehenden Ansprüche, wobei die integrierte Schaltung eine Verdrahtungslage ist.

7. Integrierte Schaltung nach einem der vorstehenden Ansprüche, wobei die drei PUs (110) in einer anderen Struktur als einer Matrix angeordnet sind.

8. Integrierte Schaltung nach einem der vorstehenden Ansprüche, wobei der erste Dreiwegeschalter (160), der zweite Dreiwegeschalter (161), falls vorhanden, und der Isolierungsschalter (162), falls vorhanden, Transistoren umfassen, die eine Kriechstromdichte unterhalb von 10e-14 Ampere pro Mikrometer aufweisen.

9. Integrierte Schaltung nach einem der vorstehenden Ansprüche, wobei der erste Dreiwegeschalter (160), der zweite Dreiwegeschalter (161), falls vorhanden, und der Isolierungsschalter (162), falls vorhanden, durch eine Steuerung gesteuert werden.

10. Elektroniksystem, umfassend eine integrierte Schaltung nach einem der vorstehenden Ansprüche.

11. Verwendung einer integrierten Schaltung (100) nach Ansprüchen 1 bis 9 für eine Punkt-zu-Zweipunkt-Signalkommunikation mit niedrigem Energieverbrauch zwischen den drei PUs (110).

12. Verfahren zur Herstellung einer integrierten Schaltung (100) nach einem der Ansprüche 1 bis 9, das Verfahren umfassend:
- Bilden einer mehrschichtigen Metallisierung (150) oben auf einem Substrat (101);
- Bilden von mindestens drei PUs (Verarbeitungseinheit, 110), wobei jede PU (110) einen aktiven Teil im Substrat (101) oder in der mehrschichtigen Metallisierung (150) umfasst, wobei jede PU (110) weiter einen Verbindungsteil und einen Schnittstellenpunkt (112) in der mehrschichtigen Metallisierung (150) umfasst;
- wobei Bilden der mehrschichtigen Metallisierung (150) Bilden einer Vernetzung (165) umfasst, die die drei PUs (110) bei den Schnittstellenpunkten (112) jeder PU (110) verbindet, wodurch Punkt-zu-Zweipunkt-Kommunikation zwischen den drei PUs (110) über die Vernetzung (165) ermöglicht wird;
wobei:
Bilden der Vernetzung (165) Bilden eines ersten Dreiwegeschalters (160) umfasst, der in der mehrschichtigen Metallisierung (150) eingebettet ist, die mit den drei PUs (110) durch drei Vernetzungssegmente (170) verbunden ist, wobei die drei PUs (110) so gebildet sind, dass der Schnittstellenpunkt (112) jeder der drei PUs (110), die mit ihrem entsprechenden Vernetzungssegment (170) der Vernetzung (165) verbunden sind, die Ecken eines spitzwinkeligen Dreiecks bilden, wodurch der erste Dreiwegeschalter (160) im spitzwinkeligen Dreieck liegt.

13. Verfahren zur Herstellung einer integrierten Schaltung nach Anspruch 12, wobei mindestens ein Vernetzungssegment (170) einen Isolierungsschalter (162) umfasst, der in der mehrschichtigen Metallisierung (150) eingebettet ist.

## Revendications

1. Circuit intégré (100), comprenant :
- au moins trois unités de traitement, PU (110), chaque PU (110) comprenant une partie active et un point d'interface (112), et ;
- une métallisation multiniveau (150) comprenant : une partie de connexion de la PU (110), une interconnexion (165) connectant les trois PU (110) au niveau des points d'interface (112) de chaque PU (110), permettant ainsi une communication point-à-deux-points entre les trois PU (110) sur l'interconnexion (165) ;
**caractérisé en ce que**,
l'interconnexion (165) comprend trois segments d'interconnexion (170) et un premier commutateur à trois voies (160) imbriqué dans la métallisation multiniveau (150), le commutateur à trois voies (160) étant connecté au point d'interface (112) des trois PU (110) par le biais des trois segments d'interconnexion (170), dans lequel les points d'interface (112) de chacune des trois PU (110) avec son segment d'interconnexion correspondant (170) forment les angles d'un triangle acutangle, et dans lequel le premier commutateur à trois voies (160) est situé dans le triangle acutangle.

2. Circuit intégré selon la revendication 1, dans lequel au moins un segment d'interconnexion (170) comprend un commutateur d'isolation (162) imbriqué dans la métallisation multiniveau (150).

3. Circuit intégré selon l'une quelconque des revendications précédentes, dans lequel au moins un segment d'interconnexion (170) de l'interconnexion (165) comprend au moins un second commutateur à trois voies (161), imbriqué dans la métallisation multiniveau (150), connectant le segment d'interconnexion (170) au quatrième segment d'interconnexion (190).

4. Circuit intégré selon l'une quelconque des revendications précédentes, comprenant en outre un substrat (101) sur lequel la métallisation multiniveau (150) est formée, et dans lequel la partie active de chaque PU (110) est située dans le substrat (101), ou est située dans la métallisation multiniveau (150).

5. Circuit intégré selon l'une quelconque des revendications précédentes, dans lequel au moins l'une des PU (110) est une entrée et/ou une sortie du circuit intégré (100).

6. Circuit intégré selon l'une quelconque des revendications précédentes, dans lequel le circuit intégré est un élément intermédiaire.

7. Circuit intégré selon l'une quelconque des revendications précédentes, dans lequel les trois PU (110) sont agencées selon un motif autre qu'une grille.

8. Circuit intégré selon l'une quelconque des revendications précédentes, dans lequel le premier commutateur à trois voies (160), le second commutateur à trois voies (161) s'il existe et le commutateur d'isolation (162) s'il existe comprennent des transistors ayant une intensité de courant de fuite inférieure à 10e-14 ampères par micromètre.

9. Circuit intégré selon l'une quelconque des revendications précédentes, dans lequel le premier commutateur à trois voies (160), le second commutateur à trois voies (161) s'il existe et le commutateur d'isolation (162) s'il existe sont commandés par un dispositif de commande.

10. Système électronique, comprenant un circuit intégré selon l'une quelconque des revendications précédentes.

11. Utilisation d'un circuit intégré (100) selon les revendications 1 à 9, pour une communication de signal point-à-deux-points à faible consommation d'énergie entre les trois PU (110).

12. Procédé de fabrication d'un circuit intégré (100) selon l'une quelconque des revendications 1 à 9, le procédé comprenant :
- la formation d'une métallisation multiniveau (150) au-dessus d'un substrat (101) ;
- la formation d'au moins trois PU (unité de traitement, 110), chaque PU (110) comprenant une partie active dans le substrat (101) ou dans la métallisation multiniveau (150), chaque PU (110) comprenant en outre une partie de connexion et un point d'interface (112) dans la métallisation multiniveau (150) ;
- dans lequel la formation de la métallisation multiniveau (150) comprend la formation d'une interconnexion (165) connectant les trois PU (110) au niveau des points d'interface (112) de chaque PU (110) permettant ainsi une communication point-à-deux-points entre les trois PU (110) sur l'interconnexion (165) ;
dans lequel :
la formation de l'interconnexion (165) comprend la formation d'un premier commutateur à trois voies (160) imbriqué dans la métallisation multiniveau (150) connecté aux trois PU (110) par le biais de trois segments d'interconnexion (170), dans lequel les trois PU (110) sont formées de telle sorte que le point d'interface (112) de chacune des trois PU (110), connecté à son segment d'interconnexion correspondant (170) de l'interconnexion (165), forme les angles d'un triangle acutangle moyennant quoi le premier commutateur à trois voies (160) est situé dans le triangle acutangle.

13. Procédé de fabrication d'un circuit intégré selon la revendication 12, dans lequel au moins un segment d'interconnexion (170) comprend un commutateur d'isolation (162) imbriqué dans la métallisation multiniveau (150).
